(19) Europäisches Patentamt
European Patent Office
Office européen des brevets

(11) Publication number: **0 147 248 B1**

(12) # EUROPEAN PATENT SPECIFICATION

(45) Date of publication of patent specification: **15.04.92**

(51) Int. Cl.5: **H03H 7/01**, H01B 11/12, H01P 1/201

(21) Application number: **84401657.6**

(22) Date of filing: **09.08.84**

(54) **Cable networks and filters with interfacial losses.**

(30) Priority: **10.08.83 FR 8313145**

(43) Date of publication of application:
**03.07.85 Bulletin 85/27**

(45) Publication of the grant of the patent:
**15.04.92 Bulletin 92/16**

(84) Designated Contracting States:
**AT BE CH DE FR GB IT LI LU NL SE**

(56) References cited:

**IEEE TRANSACTIONS ON ELECTROMAGNETIC COMPATIBILITY, vol. EMC-18, no. 2, May 1976, pages 59-70; F. MAYER: "RFI suppression components: State of the art; new developments"**

**P. GRIVET: "Physique des lignes de haute fréquence et d'ultra-haute fréquence", 1969, pages 25-67, Masson & Cie, Paris, FR; "Tome I: Paramètres primaires et secondaires ondes progressives impulsions"**

(73) Proprietor: **Mayer, Ferdy**
**18 rue Albert 1er**
**Luxembourg(LU)**

(72) Inventor: **Mayer, Ferdy**
**18 rue Albert 1er**
**Luxembourg(LU)**

(74) Representative: **Pinguet, André**
**Cabinet de Proprieté Industrielle CAPRI 28 bis, avenue Mozart**
**F-75016 Paris(FR)**

EP 0 147 248 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The use of low-pass wires and cables for electrical interconnections between electronic apparatus, instruments and systems, so as to make the latter "compatible" with one another (relative to conducted, coupled or radiated electromagnetic interference), has been described in detail in the scientific and technical literature (Reference : RFI Suppression Components : State of the art ; New developments by Dr. Ferdy Mayer, IEEE-Transactions on Electromagnetic compatibility Vol. EMC-18, No 2, May 1976 pages 59-70.

These wires and cables take advantage of magnetic and dielectric losses of the conductor(s), the magnetic and dielectric absorption of the media surrounding this conductor(s), and one can realize low-pass lines, cables and filters having cut off frequencies (attenuation of 3 dB/m) of 20 MHz for straight conductor structures and 300 kHz for helical conductor structures. For frequencies above this range attenuation continues to increase and decreases occur only at frequencies above 2 to 40 GHz, where the magnetic effects disappear.

But there are many practical applications, in particular in industry and aeronautics, where a need exists to have cut off frequencies below 20 MHz or 300 kHz, so as to suppress "slower" waveforms or to reduce the necessary line or cable length. In the same way, there are cases (in particular in defence applications), where not only lower cut off frequencies are sought, but also frequencies above the 10 to 50 GHz range, where the effects of magnetic absorption (case of the use of magnetic losses) disappear.

Moreover, similar to the described magnetic/dielectric losses, there exist other physical phenomena, with inherent high frequency loss effects, i.e. low-pass characteristics, which the present invention can take advantage of, like normal skin effect in conductors, the artificial skin effect described in FR-A-1428517 and FR-A-1514178 the loss effects achieved by semiconductive or resistive materials in the conductor surrounding area, eddy currents and proximity effects due to surrounding conductors, and many other known physical loss effects.

A first aim of the invention is to extend the absorptive performance of the above-described wires/lines/cables/filters towards lower and towards higher frequencies.

A second aim of the invention, consistant with the first, is to raise the attenuation of the described wires/lines/cables/filters, for a given frequency, a typical example representing the simulated skin effect, described in my US-Patent: US-A-4510468 published 9.4.1985.

Another typical example is the possibility to replace a complicated and expensive implementation (like a helical line), by a straight wire or cable, of simple structure, both less expensive and of lower weight : this fact may be important when the weight of the interconnection is limited, such as in air-borne or space applications.

A third aim of the invention is to re-shape the attenuation curve of such a structure (in the frequency domain ), so as to achieve a desirable result : indeed, starting from the above-mentioned physical phenomena, difficult to control, one may desire to absorb certain frequency bands more and others less.

A fourth aim of the invention consists of the concept of a new type of electrical network, where, with the addition of dissimilar wire/line/cable elements, and/or the use of lumped electrical components, of the right value, and in the right location, one can optimize the desired results.

In order to explain better the principles of the invention, I recall some fundamentals relating to electrical lines - the term "electrical lines" is taken in a very general sense to include wires and cables, distributing electrical signals and/or electrical power twisted cables, cables with common mode suppression, shielded cables, rigid lines of the printed circuit type and strip-lines, filters made out of these, etc.

Such lines, with the presence of ground, form four-pole structures and generally, their electrical characteristics are defined by the series impedance of the line, and its parallel (shunt)admittance, both of them being in general complex values.

The square-root of this series impedance, divided by this shunt admittance, represents the characteristic impedance of the line, $Z_c$. The square-root of their product represents the propagation constant, of which the real part is the attenuation $\alpha$ (in dB/m), which is to be optimized, according to the invention.

The interconnection of low-loss electrical lines, is generally made by characteristic impedance matching, i.e. connectors and lines have the same characteristic impedance all-over : consequently wave reflections are avoided at the interfaces : the wave becomes "progressive", the"return-loss" is small, and the wave propagates with a minimum of losses.

According to the invention, one interconnects several line-segments, connectors etc, by associating a certain propagation length (at constant $Z_c$), with interfaces, with constant,but very different $Z_c$.

In such an implementation, there is an important characteristic impedance discontinuity; and the incident wave is essentially reflected at the interface : before arriving at the other end of the structure the wave will have passed each element several times after multiple reflections.

If now these elements represent an attenuation (even small), it appears obvious that this wave will be highly attenuated, because of these multiple reflections.

In the same way, if a characteristic impedance discontinuity intervenes by a lumped impedance (shunt capacitor, series inductance, series capacitor, shunt inductance, etc) wave reflections will take place and will create the "interfacial loss" phenomenon described, by the significant attenuation of the multply-reflected wave, due to the intrinsic attenuation in the line and/or the lumped components, even if such attenuation is only slight.

So as to explain the invention in detail, in the following description, I shall show details of the concept, in the case of interconnected lines.

The line-element of this "very different" characteristic impedance ($Z_{02}$), relative to the remaining interfaces ($Z_{01}$), will become "resonnant" for a frequency at which it represents a quarter-wavelength (λ/4) and its odd-integer multiples.

A part of the wave, after a double reflection, but with an inversed polarity, will superpose to the initial wave, giving by addition,a sum close to zero; i.e. a maximum of attenuation will take place. Indeed, the wave will undergo a reflection equal to

$$\frac{Z_{01} - Z_{02}}{Z_{01} + Z_{02}}$$

i.e. close to $Z_{01}/Z_{02}$, in magnitude, if the discontinuity is significant. In this case one can easily demonstrate that the amplitude reduction (corresponding to this maximum of attenuation) is equal to

$$1/2 \sqrt{Z_{01}/Z_{02}} .$$

On the other hand, for a line-length of half a wavelength (λ/2 and its even multiples), a minimum of attenuation will take place - reflecting the intrinsic loss of the line.

Attenuation versus frequency will so represent periodic fluctuations between maxima and minima; this oscillation taking place around a curve which represents the attenuation proper of the elements, plus two times the described maximum loss for the odd-quarter wave multiple case.

The amplitude of such fluctuations will decrease, when the frequency increases, when the attenuation of one or several elements increases (and inversely).

The amplitude of the attenuation maxima may become much higher than the intrinsic losses of the elements : independantly from these intrinsic losses, this value represents the " mismatch losses" or "interfacial losses" according to the invention.

The invention is based upon such a "multiplication" of the intrinsic attenuation of the elements.

One can observe , that several "resonating" line elements of this kind (i.e. strongly mismatched with the interfaces) will add their attenuations, if they are decoupled one relative to the other (as obtained for example by interleaved lossy line segments, or lossy components, where a practical decoupling may be achieved by an attenuation as small as 0,2 dB).

Without such decoupling losses, a practical decoupling will not occur and overall losses will remain those of the addition of the intrinsic losses of the elements. The maximum attenuation is achieved, when the attenuation of the element(s) and the interface(s) are identical.

Several specially interesting cases should be considered, in the scope of the invention :

1) Several "resonating" elements in cascade (and separated by decoupling elements), have the same electrical length : In this case their attenuations, which are the same, for a given frequency simply add together and important maxima and minima of attenuation are obtained, in the frequency spectrum : the result is a multiplication of the attenuation curves, and of the attenuation slope of the simple element considered.

2) The several "resonating" elements have electrical lengths, one double (or half) of the other : the attenuation maxima of one of the elements λ/4 or (2n -1) λ/4, will coincide (in the frequency domain ) with a minimum of attenuation of the other : in this way the fluctuations of attenuation vs frequency can be attenuated. With a number of elements, chosen in such a manner, a broadband absorptive filter can be designed, beginning from the lowest frequency at which the first quarter-wavelength with an intrinsic attenuation of a few tenths of dB appears.

3) The several "resonating elements", with their lengths chosen appropriately, and with corresponding attenuation values, allow desired attenuation curves to be synthezised.

In addition, with the use of lines, of which the electrical length varies with frequency (dispersive dielectric and magnetic media), practically all shapes of attenuation curves are possible, with specific localized coincidences in frequency, and not for all frequency multiples.

The above mentioned need to have a minimum of attenuation available, so as to create the interfacial loss effect, is optimised through the use of the low-pass cables (with magnetic and dielectric losses) mentioned at the beginning.

So as to explain the invention in detail, a series of test-results will be described, by means of the graphs of figures 3 to 12, using the cables of figures 1 and 2, representing achieved attenuation versus frequency, and demonstrating the principles exposed above.

First, one considers, as an example, the case of mismatched low-pass lines in cascade, implemented by two types of flexible absorptive low-pass cables, of characteristic impedance of 50 Ω and 1900 Ω. The structure of the first cable is described in figure 1, in a coaxial implementation, where a copper-conductor is surrounded by the commercially known magnetic absorptive composite MUSORB. This composite is then covered by a thin insulating layer, and in turn by a classical conductive shielding braid. As a direct consequence of this, the cable uses a straight conductor with both a reduced distributed inductance and a high distributed capacitance relative to ground (due to the thin dielectric insulation and the high permittivity of the absorptive composite).

The cable of figure 1 uses a copper conductor 1, of diameter 1,5 mm, with a surrounding absorptive composite 2 of diameter 5,5 mm, a PVC-layer 3 of diameter 6,5 mm and the shield 4. For such a cable the distributed inductance L is 2,7 µH/m, the distributed capacitance C is 1050 pF/m and the characteristic impedance $Z_{01} \cong 50$ Ω.

Therefore this cable has a low characteristic impedance, which can be realized through many other methods, as is known in the art.

In contrast the second cable, figure 2, shows a high characteristic impedance : a copper conductor 5, of diameter 0,3 mm is wound on a core of the same absorptive composite 6, of diameter 3 mm, with a pitch of 30 turns per sentimetre. A dielectric foam 7, of outer diameter of 6 mm is placed around the winding, and finally a conductive screen 8 is applied around the structure. For such a cable, the distributed inductance L is 310 µH/m, the distributed capacitance C is equal to 86 pF/m and the characteristic impedance increases to $Z_{02} \cong 1900$ Ω.

This cable uses a helical conductor, achieving a high value of distributed inductance, and a reduced ground-capacitance, due to the dielectric foam insulation, with a relative permittivity close to one.

It is further evident that this cable, with a high value of characteristic impedance, can have many implementations, as known in the art. In particular, if a straight conductor is desired, one can use a structure as shown in figure 1, with a low permittivity insulation, a thicker insulation, a magnetic surface conductor (raising the internal inductance), etc.

The test series results, of which the description now follows, has been made with standard MIL-STD-220A test equipment, i.e. with a characteristic impedance of 50 Ω : in other words, the cable of figure 1 will be perfectly matched. On the other hand, the very design of the second cable, figure 2, introduces mismatch losses. For this reason, fixed attenuations, of 10 dB each, are connected so as to avoid disturbance of the generator (G) and test receiver (SA).

Figure 3 shows the attenuation vs frequency curve with the high-characteristic impedance cable : one can see that the quarter-wavelength for the 0,52 m length of the helical line corresponds to 3,6 MHz, basic attenuation of the line as shown by the dotted curve, is equal to approximately 1,4 dB at that frequency. The ratio $Z_{01}/Z_{02}$ corresponds to interfacial losses of $1/2 \sqrt{Z_{01}/Z_{02}} = 6{,}2$ ne-per/m, i.e. 15,7 dB/m, which is close to the experimental value.

The "half wavelength" corresponds to 7,2 MHz, and its multiples, with the expected attenuation minima. The amplitude of the fluctuations decreases with increasing frequency, and above 60 MHz approximately, no reflected wave can reach the output anymore.

Figure 4 shows the results with the same helical line, but of double length, i.e. 1,05 m : one sees, that resonance frequencies are now halved, and the basic attenuation (corresponding to the dotted line of figure 3) has now doubled.

Figure 5 shows two elements of the short helical line, separated by a "decoupling" element of the low impedance coaxial line, showing a minimum attenuation of several tenths of dB in the few MHz range . One again sees , that the total attenuation corresponds to the addtion of the attenuation of two cascaded helical line elements, plus the attenuation of the straight absorptive line : the attenuation at 3,6 MHz and its odd multiples has doubled (addition of the attenuation of two quarter-wavelengths), the even multiples showing minima at 7,14, ... MHz.

One can observe too the different evolution of the attenuation maxima and minima, with frequency. This is due to an incorrect adjustment of the two helical line elements.

In figure 6, the length of one of the helical elements has been halved (lengths = 0,52 m and 0,26 m), so as to obtain a first quarter-wavelength at 7,2 MHz, the other appearing at 3,6 MHz : these two frequencies are effectively absorbed to a high degree.

The above shows the method of synthezising partial response curves, in order to achieve, amongst others, a continuous absorption curve.

This is shown clearly by several additional tests. For example, three elements of helical lines (lengths = 1,04, 0,52 and 0,26 m) separated by two straight low-pass conductor lines of 1,65 m length show a "broad band" response, with essentially the suppression of all resonances (figure 7). With a 3 dB cut-off frequency at approximately 200 kHz, the attenuation reaches 33 dB at 2,0 MHz, and an attenuation equal to or in excess of 40 dB is achieved from 2,6 MHz to above 20 GHz.

A final addition of a 0,13 m long helical line, decoupled by still another length of 1,65 m of the straight coaxial line, shows the results of figure 8.

This implementation, despite the fact that it is not optimized, demonstrates the very significant broad-band filter action, made possible by the invention.

It can be further deduced that for a given total length of lines, higher values of attenuation can be achieved than with a uniform absorptive line of equal length composed totally of the line of the highest attenuation.

In the same way, attenuation slopes can be much higher, as indeed the slope is proportional to the interface reflexions (compare slope of figures 3 or 4 to figures 5 or 6).

The first slope, before the first quarter-wavelength is important in filter design : it can be placed anywhere one wishes within the absorptive spectrum of the lines, through the correct choice of the attenuation of the specific element (length of cable), in conjunction with the appropriate choice of the lengths of the quarter-wavelength elements.

Such line types, as well as their lengths, are obviously not limited in their structures and implementations : the realization of different characteristic impedances is well known in the art : similarly, loss effects which have been shown to be indispensable, may be of any type.

Magnetic and dielectric loss wires and cables, as described in my US-patent application CIP-N° 202654, maximise performance, as shown through these examples.

The second case considered is the use of electrical lines interfaced with lumped components, shunt capacitors and/or series inductors, amongst others, introducing an impedance discontinuity.

In figure 9, test results are shown with a length 1,65 m of

a) a straight normal copper cable and

b) an absorptive cable, interfaced on both sides with 4,7 nF classical capacitors (not of the feed-through type), soldered with "pigtails" of about 5 mm length.

Curve a), with the low-loss cable, shows clearly the reflection effects, due to the cable, and a typical increase of attenuation up to 30 MHz, the resonant frequency of the capacitors. Above 30 MHz where the capacitors become inductive, they contribute little to the attenuation interface reflections appear clearly, separated by 29 MHz - i.e. the half-wavelength of the length of the cable, as one can check easily, taking in account the relative permittivity of 3 of the dielectric. Such a high frequency attenuation is impractical for use as a filter.

Curve b) corresponds to the implementation with the lossy cable of figure 1. The first quarter-wavelength, at 8,5 MHz shows up clearly; as well as the attenuation maximum at the capacitor's self-resonance. Above, the mismatch loss effect contributes to an overall attenuation superior to 60 dB, up to and above 10 GHz.

In a similar fashion, one can place two inductors in series with a low pass cable : the results are identical, with the manifestation of the self-resonance of the inductors. One may use, as well, series inductors in combination with parallel capacitors, etc., to introduce the impedance discontinuities on the line.

An immediate application of such a combination of one (or several) elements of low-pass cables (described in case b) above), with lumped components at the interfaces, is the implementation of power-line extension cords, with built-in low-pass filter action where, for example, the lumped component(s) are placed inside the connectors; if one considers that the low-pass cable can be wound and placed inside a box, with the interface components, then classical black-box filters, can also be achieved.

So as to show the general use of these principles, as described in the invention, three other examples will be shown, in different product areas, in figures 10 to 12.

In figure 10, the case of a strip-line low-pass filter is considered :

This filter consists in

- a conductive substrate
- a magnetic absorptive tape of 3 cm width and 2 mm thickness
- a "hot" electrode implemented by
  - a) two segments of 3 cm width and 10 cm long of characteristic impedance of 10 Ω, separated by one segment of 1 mm width and 8 cm long, resulting in a characteristic impedance of approximately 100 Ω.
  - b) one segment only of 28 cm length of 10 Ω of characteristic impedance.

Curve a) shows the interfacial losses (with a first quarter-wavelength resonance at 160 MHz approximately), due to the discontinuity with the 50 Ω test-circuit impedance.

Curve b) shows the mismatch losses (with a first quarter-wavelength resonance at 45 MHz), i.e. approximately a third, which is due to the fact that the 100 Ω line segment is three times the length of the conductor in curve a).

This is a typical case, where superimposing of multiple resonances (4 impedance jumps) permits better low-pass performance, for a given overall length of the line. This is a typical example of low-pass filter implementation on striplines, or on printed circuits.

In figure 11, the line element with characteristic impedance discontinuities consists of a small coaxial component, which may be placed in the inner bore of an automotive spark-plug. Curve a) shows the measured attenuation with a semi-conductive layer resistor of 16 K Ω, a classical component used for ignition-interference suppression in the USA. The curve serves as reference, so as to show the vastly improved performance possible, in the useful 30 MHz to 1 GHz frequency range (SAE standard J 551).

Curve b) shows a classical inductor, on a ceramic core, used too as a high volume suppressor item in the USA.: one can see clearly the numerous interface resonances (with $\lambda/4 \cong 25$ MHz) - resonances which are barely damped, as this inductor has very low losses.

Curve c) corresponds to an inductor of 170 µH, wound with less turns than the inductor in b) around an absorptive magnetic core, using the composites described earlier. Resonances are heavily damped, and one can see clearly the superimposition of the self-resonance of the inductor (compare with figure 9 and the above text describing a series inductor, with its self-resonance).

This example further illustrates, that at higher frequencies, in a quasi-coaxial structure (i.e. with the presence of ground a component behaves like a length of an electrical line : if now the characteristic impedance of such a four-pole structure is quite different from the impedance of the interfaces (which is clearly the case here , interfacial losses will appear, whenever a basic intrinsic loss is present.

These mismatch losses give an essential advantage to such a component, in specific applications : for identical overall dimensions of the component , the inductor c) shows a distinctive improvement in the RFI-attenuation, resulting in less conducted and radiated ignition-interference .

This type of distributed spark plug inductor can, of course, be an integral part of the ignition wire, as an extension of the spark-plug circuit. In such a case, a segment of high characteristic impedance cable is placed, for example, at both ends of the ignition wire, i.e. close to the RFI sources (the spark plug and distributor sparks), each of them representing, for example, quarter-wavelengths for one or two selected frequencies, where an attenuation pole is desirable, as, for example, at 30 MHz, the lowest frequency to be suppressed, of the CISPR spectrum; the central part of the cable showing a reduced characteristic impedance, and representing the decoupling line segment. One can verify that an optimum attenuation vs frequency design can be achieved, with better low frequency absorption (where the magnetic absorption is low) and the possibility of a less expensive design through the use of less conductor length for a given length of the cable.

The same small absorptive and inductive component, can of course be placed close to a circuit board ground plate, implementing an "open" four-pole structure, and soldered as any classical component or surface-mound device : similar broad-band attenuation characteristics will be obtained - completely different from classical "chokes", showing a self-resonance in the 10 MHz range, frequency above which there will be no choke effect any more.

In the following, several typical line implementations will be described, with coexistant very low and very high characteristic impedances, following the invention. The known art can be applied for such a design, by inspection of known equations for characteristic impedance calculations. For example, for a coaxial structure, the equation for characteristic impedance shows :

- for the design of a low impedance, one has to use :
  - a high permittivity for the insulation
  - a ratio of screen to conductor diameter close to one (or in an open structure, a conductor close to ground or to the return wire)
  - a series inductance of the line as low as possible, i.e. a straight conductor, and a reduced space (of external inductance), with the absence of (a high) magnetic permeability.
- for the design of a high an impedance line, to be interconnected with the above line, to achieve a significant impedance jump , one needs, on the contrary :
  - a low permittivity of the insulating layer, with the use of an air-space or foamed materials
  - a high value of conductor to screen, ground, or return conductor spacing
  - a line inductance as high as possible, with, in particular, the use of magnetic materials and helical conductors.

In the particular case of lines, where the ground or return conductor is far away (wires in free space, as for example hook-up wires, ignition wires, common mode suppressor cables, etc), one can merely adjust accordingly the series inductance of the line, with (absorptive) magnetic materials : helixes with widely different pitches are then useful. The inverse is true, when ground is close to the conductor, where action can be taken essentially through the shunt parameters of the line.

Figures 1 and 2 describe the design of two such lines to achieve a significant discontinuity of characteristic impedance : as their structures are different, their application is useful, above all, for interconnected networks, where different kinds of cables are connected together. With these examples, a ratio $Z_{01}/Z_{02}$ of 38 is achieved, but obviously smaller discontinuities whilst showing lesser attenuation, are nevertheless useful. With the above mentioned principles, it is easy to see, that a similar result may be obtained, on the one hand with open low-pass wires (hook-up wire or common mode suppression coaxial cable placed close to one another or to ground, or a return wire) and on the other hand, the same wire or cable coiled, far from ground. Such layouts correspond to particularly simple and inexpensive implementations of elementary interfacial loss networks. For example, an absorptive hook-up wire layout, such as power supply lines, interconnecting lines. etc., of about 30 cm length, inside an electronic instrument, using a straight mid-section of 15 cm length, close to ground, and two coiled end sections of coil diameter of 4 mm , suspended in free air, (or greater coil diameter, with three or four turns, flattened and placed close to ground), show approximately double the attenuation (compared to the same length of strait hook-up wire, placed close to ground) in the 40 to 100 MHz range (i.e. 10 to 20 dB approximately, instead of 5 to 10 dB).

It is still another object of the invention to describe continuous cable structures, where the characteristic impedance discontinuity is included, by manufacture .

The same principles apply and show many different possible means of implementation A few examples which are not exhaustive will be given:

- variation of the permittivity of the dielectric, for a given geometry, with a straight or helix conductor
- variation of the composition of an absorptive composite, so as to show ad hoc values of permittivity and/or permeability variations of the classical insulating material to a magnetic insulator
- abrupt variation of the pitch of an helix, varying from a very long pitch (equivalent to a straight conductor) to a very short pitch (down to close-wound helix). This last solution is of special interest in the case of a more distant ground reference (ignition cables, for example).

Numerous variants can thus be conceived, which can be manufactured by continuous extrusion process, with a double injection head, with winding machines with controlled advance of the core, etc. Other variants may be processed with the inclusion, during automatic manufacture, of quasi-lumped cores, washers, halfsegments etc, of appropriate electrical and/or magnetic characteristics, similar to the manufacturing of certain coaxial cables, where the centre conductor is kept in place, by intervals, by dielectric washers.

Similar considerations are applicable to other line, cable, filter structures in the broadest sense, as already emphasized : i.e. all wave propagating structures, with distributed line constants, where an assembly with widely different characteristic impedances/lumped impedance segments can be achieved.

To summarise the first aspect of the invention describes the possibility to design lossy filters, by assembling of different lines and lengths, or by a continuous manufacturing process.

A further subject to be considered is the case of different lines, in a network, with multiple interconnections. This is the case, for example, in the internal wiring of an electronic apparatus, instrument, or, on a higher level, the wiring of a system, on a ship, a plane, a satellite etc, where electromagnetic compatibility is to be achieved to protect against various phenomena such as EMP.

A third subject to be considered is the case of an industrial power distribution network, with uniform wire/cable segments, but with different impedances and/or with correctly placed lumped impedances, in the network.

Obviously, in the second and third subjects above , the longer lengths of the wires/cables of the network, allow the implementation of lower cutoff frequencies, and, possibly, as low as the frequency harmonics of the power supply itself : the interest for harmonic suppression due to electronic commutation for example DC-motors, due to semiconductor power-switching (Triacs, etc) is evident.

Figure 12 shows an example of the implementation of the invention, in a uniform low-pass power distribution line. Whereas, the low-pass line alone, for a 20 m length, shows a 20 dB attenuation for about 10 MHz - the addition of a lumped 22 nF capacitor at each end, gives the networks a 20 dB attenuation for a frequency as low as 1 MHz.

In addition to such power network applications, with the concept of RF-decoupling from one point of the network to the other, the application to electrical train overhead power lines and high-voltage power lines is possible , where greater line lengths are used with the corresponding possibilities of increased attenuation. In such a case, the implementation of characteristic impedance discontinuity is limited to the addition of certain lumped components, to the variation of ground (and inter-wire) capacity, and to variations of distributed series inductance : the artificial skin effect in my US-patent N° 3573676 is a typical method to introduce simultaneously the required minimum loss as well as the characteristic impedance discontinuity.

In all the above description of my invention several line structures have been cited in the examples : obviously any type of wave propagating structure may be used - in which the four-pole nature can describe a characteristic impedance, as well as an attenuation.

Such wave propagating structures may be open or closed (the above-mentioned hook-up wire close to ground, or the coaxial line); they may be symmetrical or dissymetrical (for example, twinaxial cable, twisted pair, etc), they may be straight or helical.

Finally the low-pass function may be applied separately to the differential mode (example: coaxial cable) or to the common mode (for example: common mode suppressor cable, where the absorptive function is achieved at the external side of a coaxial line, etc), or mixed structures with selected absorption of the two modes - as described for example in my US-patent application N° 351 493.

The above examples have been described with magnetic absorptive low-pass lines/cables, where the attenuation increased with frequency - accordingly to the invention, and the absorption spectrum of the lines/cables/filters has been extended towards lower frequencies.

Similarly, the interfacial loss effect described, can be used to increase the absorption in the frequency range where the applied physical loss-effects decrease for increasing frequencies : this is the case above 5 to 50 GHz, which is dependant on the particular magnetic/dielectric materials used.

## Claims

1. Electromagnetic filter composed of at least one electrical line or another distributed wave propagating structure with, connected at one or both of its ends, at least one other distributed line or lumped component, characterised in that the one electrical line has a length of at least a quarter of the wavelength corresponding to the stopband of the electromagnetic filter and provides a loss of at least 2 dB and that the characteristic impedances of the connected distributed lines and/or the impedances of the lumped components are chosen such that impedance-discontinuties are introduced compared with the characteristic impedance of the one electrical line or wave propagating structure.

2. Electromagnetic Filter, according to claim 1, characterized by implementation of such electromagnetic losses by electric and/or magnetic absorption losses, by normal and artificial skin effect, by simulated skin effect, by eddy current and proximity effects, and other physical loss effects, inside the specific frequency range.

3. Electromagnetic Filter, according to claims 1 or 2, characterized by a minimum number of 2 characteristic impedance discontinuities, so as to produce the interfacial losses, and by the appearance, for significant discontinuities, of interfacial losses equal to half of the square root of the ratio of the impedance discontinuity.

4. Electromagnetic Filter, according to claims 1 to 3, characterized by at least one distributed mismatched line element representing an odd quarter-wavelength multiple for a given frequency, at which it represents a maximum of attenuation.

5. Electromagnetic Filter, according to clams 1 to 3, characterized by at least one line element representing a halfwave multiple for a given frequency, at which it represents a minimum of attenuation.

6. Electromagnetic Filter , according to claims 1 to 5, characterized by the cascading of several mismatched line elements (with decoupling interface lines) and presenting an addition of the attenuation characteristics.

7. Electromagnetic Filter, according to claim 6, characterized by cascading of several odd multiple quarter-wave elements (with decoupling interface lines) and presenting a pole of attenuation for the corresponding frequencies, so as to increase absorption at certain frequencies, with a maximum attenuation slope, proportional to the number of cascaded elements.

8. Electromagnetic Filter, according to claims 4 to 7, characterized by the cascading of several elements of different electrical lengths (with decoupling interface lines), so as to achieve (at given frequency) the superposition of maximum attenuation effect (with odd quarter-wave line segments), with the minimum attenuation effects, as shown by multiple halfwave segments, so as to broaden overall attenuation versus frequency, and to cancel out absorption minima.

**9.** Electromagnetic Filter, according to claims 1 to 3, characterized by at least one distributed line element and at least one lumped series inductor component, and/or one lumped shunt capacitor component.

**10.** Electromagnetic Filter, according to claim 9, characterized by the fact that at least one of the lines or components has to show intrinsic absorption, according to claim 2.

**11.** Electromagnetic Filter, according to claims 9 and/or 10, characterized by the fact that the component(s) which introduce discontinuity is itself characterized by non-ideal inductive or capacitive behaviour, i.e. introducing one or several eigenresonances, and that these are combined with the mismatch-filter effect so as to achieve a maxima of attenuation, maxima of attenuation slope and/or a further broadening of the filter performance.

**12.** Electromagnetic Filter, according to claims 1 to 11, characterized by the positioning of the mismatch loss effect onto the (small) intrinsic losses of the lines and/or components, according to claim 1, in the increasing losses (versus frequency) portion of the spectrum, so as to extend the useful filter effect towards lower frequencies, or in the decreasing losses (versus frequency) portion of the spectrum, so as to extend the useful filter effect towards higher frequencies.

**13.** Electromagnetic Filter, according to claims 1 to 12, characterized by the application of the improved low-pass function to differential mode propagation on the Filter, to commun mode propagation on the Filter, or to both together.

**14.** Electromagnetic Filter, according to claims 1 to 13, characterized by the application to a line or any electro-magnetic propagation structure, of the closed type (coaxial cable, twisted pair, etc) or of the open type (hook-up wire, common mode suppressor coaxial cable, etc) or to any structure using both.

**15.** Electromagnetic Filter, according to claims 1 to 14, characterized by a continuously manufactured cable-like structure, introducing the impedance discontinuities by continuous/discontinuous processing technique.

**16.** Electromagnetic Filter, according to claims 1 to 14, characterized by a cascade of different characteristic impedance wires, cables, filters interconnected in situ, as in the practical case of the wiring of electrical/electronic apparatus, signal and power distribution network's.

**17.** Electromagnetic Filter, according to claims 1 to 15, characterized by a low-pass wire/cable/filter in association with one or several lumped series inductors and/or series shunt capacitors, advantageously placed inside connectors, for the implementation of filter power-line extension cords, and power supplies for filtered appliances.

**18.** Electromagnetic Filter, according to claims 1 to 17, characterized by a lossy coaxial distributed constants inductor as high characteristic impedance line segment, interfaced with lower impedance circuits, as a broad-band RFI-suppressor component for electronic circuits.

**19.** Electromagnetic Filter, according to claim 18, characterized by the implementation of the lossy high characteristic impedance line segment, as a filter component, to be used in a coaxial configuration (spark plug RFI inductor), or a close to ground configuration (use on ignition wires, electronic PC-board application). 43

**20.** Electromagnetic Filter, according to claims 1 to 19, characterized by one/several elements of low-pass lines with high characteristic impedance, with one or several decoupling interface line segment(s) of low characteristic impedance, as used as an automotive ignition interference suppressor cable, and characterized by the positioning of the high impedance segments close to the interference sources, i.e. the ends of the cable.

**21.** Electromagnetic Filter, according to claim 20, characterized by a cable with an alternate close wound and spaced winding pitch, with abrupt transitions , to achieve interfacial losses on an automotive ignition wire, with advantageously cascading of one or several absorption poles, according to claims 5 and 8, inside the CISPR/SAE frequency band, for the RFI-suppression of land-mobiles and in particular specific suppression frequencies (CB, radio, telephone, cellular telephone, etc), and possibly outside the CISPR/SAE band, for further suppression requirements (radio, TV, communications, etc).

**22.** Electromagnetic Filter, according to claims 1 to 21, which is achieved by an absorptive open wire/line, with interfacial losses to improve the filter performance of a connection in situ :

- with one or several low characteristic impedance segments (straight wire placed close to ground), interfaced with a higher characteristic impedance network,
- with one or several high characteristic impedances segments (the same straight wire far from ground and/or coiled as a helix) interfaced with a lower characteristic impedance network,
- with both implementations combined, in the same electrical interconnexion,

such filters being useful in black-box filters, in particular for the extension to higher frequencies of the traditional Limited black-box filter attenuation performances.

**23.** Electromagentic Filter, according to claims 1 to 22, for the implementation of at least partially flexible filter-lines, using flexible line elements made by conventional cable-processing technique (extrusion, etc).

**24.** Electromagnetic Filter, according to claims 1 to 22, for the implementation of semirigid or essentially rigid filters in stripline, printed circuit board and integrated filter technology.

**25.** Electromagnetic Filter, according to claims 1 to 23, where the main conductor/s are bare, for the filtering of high-voltage lines, electrical train power- supply lines etc.

**26.** Electromagnetic Filter, according to claims 1 to 25, where interconnections of signal/power supply network lines/cables, use the mismatch loss approach, so as to achieve given attenuation versus frequency performance between given inlets/outlets of the networks.

## Revendications

**1.** Filtre électromagnétique composé d'au moins une ligne électrique ou une autre structure à propagation d'onde distribuée, ayant, connectée à une de ses extrémités ou à ses deux extrémités, au moins une autre ligne distribuée ou un composant localisé, caractérisé en ce que la au moins une ligne électrique a une longueur d'au moins un quart de la longueur d'onde correspondant à la bande de coupure du filtre électromagnétique et représente une perte d'au moins 2 dB et en ce que les impédances caractéristiques des lignes distribuées connectées et/ou les impédances caractéristiques des composants localisés sont choisies telles que des discontinuité d'impédance sont introduites, comparées à l'impédance caractéristique de la au moins une ligne électrique ou structure à propagation d'onde.

**2.** Filtre électromagnétique selon la revendication 1, caractérisé par la mise en oeuvre de telles pertes électromagnétiques par perte d'absorption électrique et/ou magnétique, par effet de peau normal et artificiel, par effet de peau simulé, par courant de Foucault et effets de proximité, et par d'autres effets physiques de perte, dans la plage de fréquence spécifique.

**3.** Filtre électromagnétique selon la revendication 1 ou la revendication 2, caractérisé en ce que les discontinuités d'impédance caractéristiques sont au moins égales à 2 de façon à produire les pertes interfaciales, et caractérisé par l'apparition pour des discontinuités significatives, de pertes interfaciales égales à la moitié de la racine carrée du rapport de la discontinuité d'impédance.

**4.** Filtre électromagnétique selon les revendications 1 à 3, caractérisé par au moins un élément de ligne distribuée désadaptée représentant un multiple impair du quart de la longueur d'onde pour une fréquence donnée à laquelle il représente un maximum d'atténuation.

**5.** Filtre électromagnétique selon les revendications 1 à 3, caractérisé par au moins un élément de ligne représentant un multiple de demi-onde pour une fréquence donnée, à laquelle il représente un minimum d'atténuation.

**6.** Filtre électromagnétique selon les revendications 1 à 5, caractérisé par la mise en cascade de plusieurs éléments de ligne désadaptés (avec des lignes d'interface pour le découplage) et présentant une addition des caractéristiques d'atténuation.

**7.** Filtre électromagnétique selon la revendication 6, caractérisé par la mise en cascade de plusieurs éléments multiples impairs de quart d'onde (avec des lignes d'interface pour le découplage) et présentant un pôle d'atténuation pour les fréquences correspondantes,de façon à augmenter l'absorption à certaines fréquences, avec une pente d'atténuation maximale proportionnelle au nombre d'éléments mis en cascade.

**8.** Filtre électromagnétique selon les revendications 4 à 7, caractérisé par la mise en cascade de plusieurs éléments de différentes longueurs électriques (avec des lignes d'interface de découplage) de façon à obtenir (à une fréquence donnée) la superposition de l'effet d'atténuation maximum (avec des segments de ligne quart d'onde impaires), avec les effets d'atténuation minimum comme présentés par des segments multiples de demi-onde, de façon à élargir l'atténuation générale par rapport à la fréquence, et à supprimer les minima d'absorption.

**9.** Filtre électromagnétique selon les revendications 1 à 3, caractérisé par au moins un élément de ligne distribuée et au moins un composant localisé d'inductance en série et/ou un composant localisé de capacité en dérivation.

**10.** Filtre électromagnétique selon la revendication 9, caractérisé en ce qu'au moins une des lignes ou un des composants présente une absorption intrinsèque selon la revendication 2.

**11.** Filtre électromagnétique selon la revendication 9 ou la revendication 10, caractérisé en ce que le ou les composant(s) qui introduisent la discontinuité sont euxmêmes caractérisés par un comportement inductif ou capacitif non idéal, c'est-à-dire introduisent une ou plusieurs résonances propres, et en ce que celles-ci sont combinées avec les effets de filtre à désadaptation pour obtenir un maximum d'atténuation, un maximum de pente d'atténuation et/ou un élargissement supplémentaire de l'efficacité du filtre.

**12.** Filtre électromagnétique selon les revendications 1 à 11, caractérisé par le positionement de l'effet de perte par désadaptation sur les (petites) pertes intrinsèques des lignes et/ou des composants, selon la revendication 1, dans la partie du spectre de pertes croissantes (par rapport à la fréquence), de façon à étendre l'effet utile de filtre vers les fréquences plus basses ou dans la partie du spectre de pertes décroissantes (par rapport à la fréquence), de façon à étendre l'effet utile de filtre vers les fréquences plus élevées.

**13.** Filtre électromagnétique selon les revendications 1 à 12, caractérisé par l'application de la fonction passe-bas améliorée à la propagation en mode différentiel sur le filtre, à la propagation en mode commun sur le filtre, ou les deux ensemble.

**14.** Filtre électromagnétique selon les revendications 1 à 13, caractérisé par l'application à une ligne ou à une structure à propagation électromagnétique quelconque, du type fermé (câble coaxial, paire torsadée, etc.) ou du type ouvert (fil de connexion, câble coaxial suppresseur de mode commun, etc.) ou à toute structure utilisant les deux.

**15.** Filtre électromagnétique selon les revendications 1 à 14, caractérisé par une structure semblable à un câble fabriqué de façon continue, introduisant les discontinuités d'impédance par une technique de traitement continu/discontinu.

**16.** Filtre électromagnétique selon les revendications 1 à 14, caractérisé par une cascade de fils, câbles, filtres d'impédances caractéristiques différentes interconnectés in situ, tel que dans le cas pratique du câblage d'appareillage électronique/électrique, de réseau de distribution de signal et de puissance.

**17.** Filtre électromagnétique selon les revendications 1 à 15,caractérisé par un fil/câble/filtre passe-bas en association avec une ou plusieurs inductances localisées en série et/ou capacités localisées en parallèle en série, avantageusement placées à l'intérieur des connecteurs, pour la mise en oeuvre de prolongateurs filtres et câbles d'alimentation d'appareils filtrés.

**18.** filtre électromagnétique selon les revendications 1 à 17 caractérisé par l'utilisation de l'inductance coaxiale de pertes à constantes distribuées comme segment de ligne de haute impédance caractéristique interfacé avec des circuits de plus faible impédance, tel qu'un composant suppresseur d'interférences en radio-fréquences pour circuits électroniques.

**19.** Filtre électromagnétique selon la revendication 18, caractérisé par la mise en oeuvre du segment de ligne de perte de haute impédance caractéristique comme un composant de filtre destiné à être utilisé dans une configuration coaxiale (inductance d'interférences radio-fréquences de bougies) ou dans une configuration près de la terre (utilisation sur des câbles d'allumage, application aux tableaux de PC électroniques).

**20.** Filtre électromagnétique selon les revendications 1 à 19, caractérisé par un ou plusieurs éléments de ligne passe-bas avec une haute impédance caractéristique, avec un ou plusieurs segments de ligne d'interface de découplage ayant une faible impédance caractéristique, tel qu'utilisé dans un câble de suppression d'interférences dues à l'allumage dans un véhicule automobile, et caractérisé par le positionnement des segments de haute impédance près des sources interférence, c'est-à-dire les extrémités du câble.

**21.** Filtre électromagnétique selon la revendication 20, caractérisé par un câble ayant un pas d'enroulement alternativement petit et grand, avec des transitions abruptes, pour obtenir des pertes interfaciales sur un fil d'allumage de véhicule automobile, avec avantageusement la mise en cascade d'un ou plusieurs pôles d'absorption selon les revendications 5 à 8, dans les bande de fréquence CISPR/SAE, pour la suppression d'interférences radio-fréquences de mobiles terrestres et en particulier la suppression spécifique de fréquences (CB, radio, téléphone, téléphone cellullaire, etc.) et éventuellement à l'extérieur de la bande CISPR/SAE, pour des nécessités de suppressions supplémentaires (radio, TV, communications, etc.).

**22.** Filtre électromagnétique selon les revendications 1 à 21, qui est obtenu par un fil/une ligne ouvert (e) absorbant (e) avec des pertes interfaciales, pour améliorer la performance de filtrage d'une connexion in situ :

- avec un ou plusieurs segments de basse impédance caractéristique (fil droit placé près de la terre), interfacés avec un réseau d'impédance caractéristique plus élevé,
- avec un ou plusieurs segments d'impédance caractéristique élevée (le même fil droit éloigné de la terre et/ou enroulé en hélice) interfacé avec un réseau d'impédance caractéristique plus faible,
- avec les deux configurations combinées, dans la même interconnexion électrique,

de tels filtres étant utilisables dans les filtres "boîtes noires", en particulier pour l'extension vers les fréquences plus élevées des performances traditionnelles limitées d'atténuation des filtres "boîtes noires".

**23.** Filtre électromagnétique selon les revendications 1 à 22, pour la mise en oeuvre de lignes-filtres au moins partiellement flexibles, utilisant des éléments de ligne flexibles réalisés par une technique classique de fabrication de câbles.

**24.** Filtre électromagnétique selon les revendications 1 à 22, pour la mise en oeuvre de filtres semi-rigides ou essentiellement rigides dans la technologie des microbandes, des circuits imprimés et des filtres intégrés.

**25.** Filtre électromagnétique selon les revendications 1 à 23, dans lequel le (les) conducteur (s) principal (principaux) est (sont) nu (s) pour le filtrage de lignes haute tension, de lignes d'alimentation en puissance de train électrique, etc.

**26.** Filtre électromagnétique selon les revendications 1 à 25, dans lequel des interconnexions de lignes/câbles de réseaux de transmission de signaux/de puissance, utilisent l'approche de perte par désadaptation, de façon à obtenir une efficacité donnée d'atténuation en fonction de la fréquence entre des entrées/sorties données des réseaux.

**Patentansprüche**

**1.** Elektromagnetisches Filter, bestehend aus wenigstens einer elektrischen Leitung oder einer anderen verteilten Wellenausbreitungsstruktur, die mit einem oder mit ihren beiden Enden an wenigstens eine andere verteilte Leitung oder ein Bauteil aus konzentrierten idealen Elementen angeschlossen ist,
dadurch **gekennzeichnet**,
daß die eine elektrische Leitung eine Länge von wenigstens einem Viertel der Wellenlänge hat, die dem Sperrbereich des elektromagnetischen Filters entspricht und eine Dämpfung oder einen Verlust von wenigstens 2 dB aufweist, und daß die charakteristischen Impedanzen der angeschlossenen verteilten Leitungen und/oder die Impedanzen der Bauteile aus konzentrierten idealen Elementen derart gewählt sind, daß Impedanzdiskontinuitäten im Vergleich mit der charakteristischen Impedanz der einen elektrischen Leitung oder der Wellenausbreitungsstruktur eingeführt werden.

**2.** Elektromagnetisches Filter nach Anspruch 1, **gekennzeichnet** durch
eine Darstellung elektromagnetischer Verluste aufgrund elektrischer und/oder magnetischer Absorptionsverluste, eines normalen und künstlichen Skin-Effekts, aufgrund eines simulierten Skin-Effekt, eines Wirbelstroms und von Naheffekten und anderen physikalischen Verlusteffekten innerhalb des spezifischen Frequenzbereichs.

**3.** Elektromagnetisches Filter nach Anspruch 1 oder 2,
**gekennzeichnet** durch
eine Mindestanzahl von 2 charakteristischen Impedanzdiskontinuitäten, um die Grenzflächenverluste zu erzeugen, und das Auftreten, für signifikante Diskontinuitäten, von Grenzflächenverlusten, die der Hälfte der Quadratwurzel des Verhältnisses der Impedanzdiskontinuitäten entsprechen.

**4.** Elektromagnetisches Filter nach Anspruch 1 bis 3,
**gekennzeichnet** durch
wenigstens ein verteiltes fehlangepaßtes Leitungselement, das ein ungerades Viertelwellenlängen-Vielfaches für eine vorgegebene Frequenz darstellt, bei welcher es eine maximale Abschwächung darstellt.

**5.** Elektromagnetisches Filter nach Anspruch 1 bis 3,
**gekennzeichnet** durch
wenigstens ein Leitungselement, das ein Halbwellen-Vielfaches für eine vorgegebene Frequenz darstellt, bei welcher es eine minimale Abschwächung darstellt.

**6.** Elektromagnetisches Filter nach Anspruch 1 bis 5,
**gekennzeichnet** durch
die Kaskadierung mehrerer fehlangepaßter Leitungselemente (mit Entkopplungsgrenzflächenleitungen) und Darstellen einer Addition der Abschwächungscharakteristiken.

**7.** Elektromagnetisches Filter nach Anspruch 6,
**gekennzeichnet** durch
Kaskadieren mehrerer ungerader Mehrfach-Viertelwellenlängenelemente (mit Entkopplungsgrenzflächenleitungen) und Darstellen eines Abschwächungspols für die entsprechenden Frequenzen, um bei gewissen Frequenzen die Absorption zu erhöhen, bei maximaler Dämpfungssteilheit, proportional zu der Anzahl der kaskadierten Elemente.

**8.** Elektromagnetisches Filter nach Anspruch 4 bis 7,
**gekennzeichnet** durch
die Kaskadierung mehrerer Elemente unterschiedlicher elektrischer Längen (mit Entkopplungsgrenzflächenleitungen), um (bei vorgegebener Frequenz) die Überlagerung eines maximalen Dämpfungseffekts (mit ungeraden Viertelwellenlängen-Leitungssegmenten) mit minimalen Dämpfungseffekten zu erzielen, wie durch Mehrfach-Halbwellensegmente gezeigt, um die Überallesdämpfung mit Bezug auf die Frequenz zu verbreitern, und um Absorptionsminima zu löschen.

**9.** Elektromagnetisches Filter nach Anspruch 1 bis 3,
**gekennzeichnet** durch
wenigstens ein verteiltes Leitungselement und wenigstens ein Induktorbauteil aus konzentrierten idealen Elementen, und/oder ein Kapazitätsbauteil aus konzentrierten idealen Elementen.

**10.** Elektromagnetisches Filter nach Anspruch 9,
**gekennzeichnet** durch
die Tatsache, daß wenigstens eine der Leitungen oder Bauteile eine Eigenabsorption aufweist, entsprechend Anspruch 2.

**11.** Elektromagnetisches Filter nach Anspruch 9 oder 10,
**gekennzeichnet** durch
die Tatsache, daß das Bauteil (die Bauteile), das Diskontinuität einführt, selber gekennzeichnet ist durch ein nicht ideales induktives oder kapazitives Verhalten, beispielsweise durch Einführen einer oder mehrerer Eigenresonanzen, und daß diese kombiniert sind mit dem Fehlanpassungsfiltereffekt, um Abschwächungsmaxima, Dämpfungssteilheitsmaxima und/oder ein weiteres Verbreitern der Filterleistung zu erzeugen.

**12.** Elektromagnetisches Filter nach Anspruch 1 bis 11,
**gekennzeichnet** durch
Anordnen des Fehlanpassungsverlusteffekts auf den (kleinen) Eigenverlusten der Leitungen und/oder Bauteile, nach Anspruch 1, in die zunehmenden Verluste (mit Bezug auf die Frequenz) eines Teils des Spektrums, um den nutzbaren Filtereffekt zu kleineren Frequenzen hin zu erweitern, oder in die abnehmenden Verluste (mit Bezug auf die Frequenz) eines Teils des Spektrums, um den nutzbaren Filtereffekt zu höheren Frequenzen hin zu erweitern.

**13.** Elektromagnetisches Filter nach Anspruch 1 bis 12,
**gekennzeichnet** durch
die Anwendung der verbesserten Tiefpaßfunktion auf die Differenzialmodenausbreitung auf dem Filter, auf die Gleichtaktausbreitung auf dem Filter oder auf beide gemeinsam.

**14.** Elektromagnetisches Filter nach Anspruch 1 bis 13,
**gekennzeichnet** durch
die Anwendung auf eine Leitung oder eine beliebige elektromagnetische Ausbreitungsstruktur des geschlossenen Typs (Koaxialkabel, verdrehte Doppelleitung usw.) oder des offenen Typs (Schaltdraht, Gleichtaktunterdrückungskoaxialkabel, usw.) oder auf eine beliebige beide Typen verwendende Struktur.

**15.** Elektromagnetisches Filter nach Anspruch 1 bis 14,
**gekennzeichnet** durch
eine kontinuierlich hergestellte kabelartige Struktur, die die Impedanzdiskontinuitäten durch eine kontinuierliche/diskontinuierliche Erzeugungstechnik einführt.

**16.** Elektromagnetisches Filter nach Anspruch 1 bis 14,
**gekennzeichnet** durch
eine Kaskade unterschiedlicher charakteristischer Impedanzdrähte, Kabel, in situ miteinander verbundener Filter, wie beim praktischen Einsatz der Verdrahtung eines elektrischen/elektronischen Apparates, von Signal- und Leistungsverteilungsnetzwerken.

**17.** Elektromagnetisches Filter nach Anspruch 1 bis 15,
**gekennzeichnet** durch
einen Tiefpaß-Draht/Kabel/Filter in Verbindung mit einem oder mehreren Induktoren und/oder Reihenparallel-Kondensatoren als konzentrierte ideale Elemente, die vorteilhafterweise innerhalb von Anschlußelementen zur Darstellung von Filter-Spannungsversorgungsverlängerungskabeln und Spannungsversorgungen für gefilterte Geräte angeordnet sind.

**18.** Elektromagnetisches Filter nach Anspruch 1 bis 17,
**gekennzeichnet** durch
einen mit Verlust behafteten Induktor mit koaxial verteilten Konstanten als Leitungssegment mit hoher charakteristischer Impedanz, das mit Schaltkreisen geringerer Impedanz kombiniert ist bzw. eine Schnittstelle bildet, als Breitband-RFI-Entstörerbauteil für elektronische Schaltkreise.

**19.** Elektromagnetisches Filter nach Anspruch 18,
**gekennzeichnet** durch
die Darstellung des mit Verlust behafteten hohen charakteristischen Impedanzleitungssegments als ein Filterbauteil zur Verwendung in einer koaxialen Konfiguration (Zündspulen-RFI-Induktor), oder als eine nahe an der Masse liegende Konfiguration (Verwendung auf Zündkabeln, elektronischer gedruckter Schaltkreisanwendungen).

**20.** Elektromagnetisches Filter nach Anspruch 1 bis 19,
**gekennzeichnet** durch
ein/mehrere Elemente von Tiefpaßleitungen mit hoher charakteristischer Impedanz mit einem oder mehreren Entkopplungsgrenzflächenleitungssegmenten niedriger charakteristischer Impedanz, wie sie als Kraftfahrzeugzündungsstö rungs-Unterdrückungskabel verwendet werden, und die gekennzeichnet sind durch das Anordnungen von Segmenten hoher Impedanz nahe an den Störungsquellen, z.B. den Kabelenden.

**21.** Elektromagnetisches Filter nach Anspruch 20,
**gekennzeichnet** durch
ein Kabel mit einem alternierenden eng gewikkelten und mit Abstand angeordneten Wikkelschritt mit plötzlichen Übergängen, um Grenzflächenverluste an einem Kraftfahrzeug-Zündungskabel zu erzielen, unter vorteilhafter Kaskadierung eines oder mehrerer Absorptionspole, nach den Ansprüchen 5 und 8, innerhalb des CISPR/SAE-Frequenzbandes, zur RFI-Unterdrückung von Landfunkeinrichtungen und insbesondere von spezifischen Sperrfrequenzen (CB, Radio, Telefon, Zellentelefon, usw.) und gegebenenfalls außerhalb des CISPR/SAE-Bands für weitere Unterdrückungsanforderungen (Radio, TV, Fernmeldeeinrichtungen, usw.).

**22.** Elektromagnetisches Filter nach Anspruch 1 bis 21, das dargestellt ist durch eine(n) absorptionsoffene(n) Draht/Leitung mit Grenzflächenverlusten, um die Filterleistung einer Verbindung in situ zu verbessern:

- mit einem oder mehreren Segmenten niedriger charakteristischer Impedanz (ein gerader, nahe an Masse angeordneter Draht) in Kombination mit einem Netzwerk hoher charakteristischer Impedanz,
- mit einem oder mehreren Segmenten hoher charakteristischer Impedanzen (derselbe gerade Draht in ferner Anordnung zur Masse oder ein als Spirale gewickelter Draht) in Kombination mit einem Netzwerk niedriger charakteristischer Impedanz, mit beiden Darstellungen in Kombination in derselben elektrischen Zusammenschaltung,

wobei derartige Filter in Black-Box-Filtern verwendbar sind, insbesondere für die Ausdehnung der Dämpfungsleistungen herkömmlicher Black-Box-Filter zu höheren Frequenzen hin.

**23.** Elektromagnetisches Filter nach Anspruch 1 bis 22, zur Darstellung von zumindest teilweise flexiblen Filterleistungen unter Verwendung flexibler Leitungselemente, die mit herkömmlichen Kabelherstellungstechniken (Extrusion, usw) hergestellt sind.

**24.** Elektromagnetisches Filter nach Anspruch 1 bis 22, zur Darstellung halbsteifer oder im wesentlichen steifer Filter in Streifenleitungen, gedruckten Schaltungskarten und in der integrierten Filtertechnik.

**25.** Elektromagnetisches Filter nach Anspruch 1 bis 23, wobei der/die Hauptleiter für das Filtern von Hochspannungsleitungen, Stromversorgungen für elektrische Züge, usw. freiliegen.

**26.** Elektromagnetisches Filter nach Anspruch 1 bis 25, wobei die Zusammenschaltungen von Signal/Stromversorgungs-Netzwerkleitungen/Kabeln Gebrauch machen vom Fehlanpassungsverlust-Lösungsweg, um zwischen gegebenen Eingängen/Ausgängen des Netzwerks eine gegebene Abschwächungsleistung mit Bezug auf die Frequenz zu erzielen.

Fig: 1

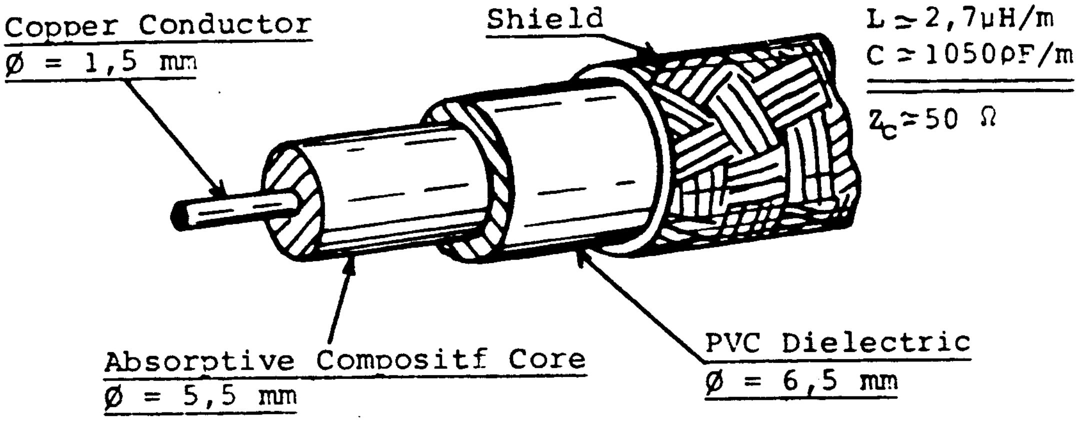
Copper Conductor
Ø = 1,5 mm
Shield
L ≃ 2,7µH/m
C ≃ 1050pF/m
Zc ≃ 50 Ω
Absorptive Compositf Core
Ø = 5,5 mm
PVC Dielectric
Ø = 6,5 mm

Fig: 2

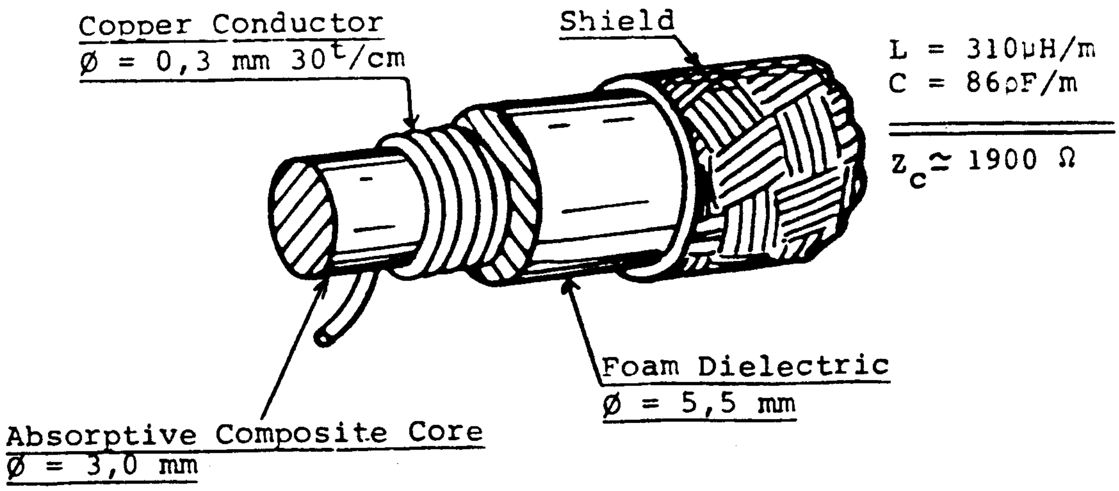
Copper Conductor
Ø = 0,3 mm 30t/cm
Shield
L = 310µH/m
C = 86pF/m
Zc ≃ 1900 Ω
Foam Dielectric
Ø = 5,5 mm
Absorptive Composite Core
Ø = 3,0 mm

Fig: 3

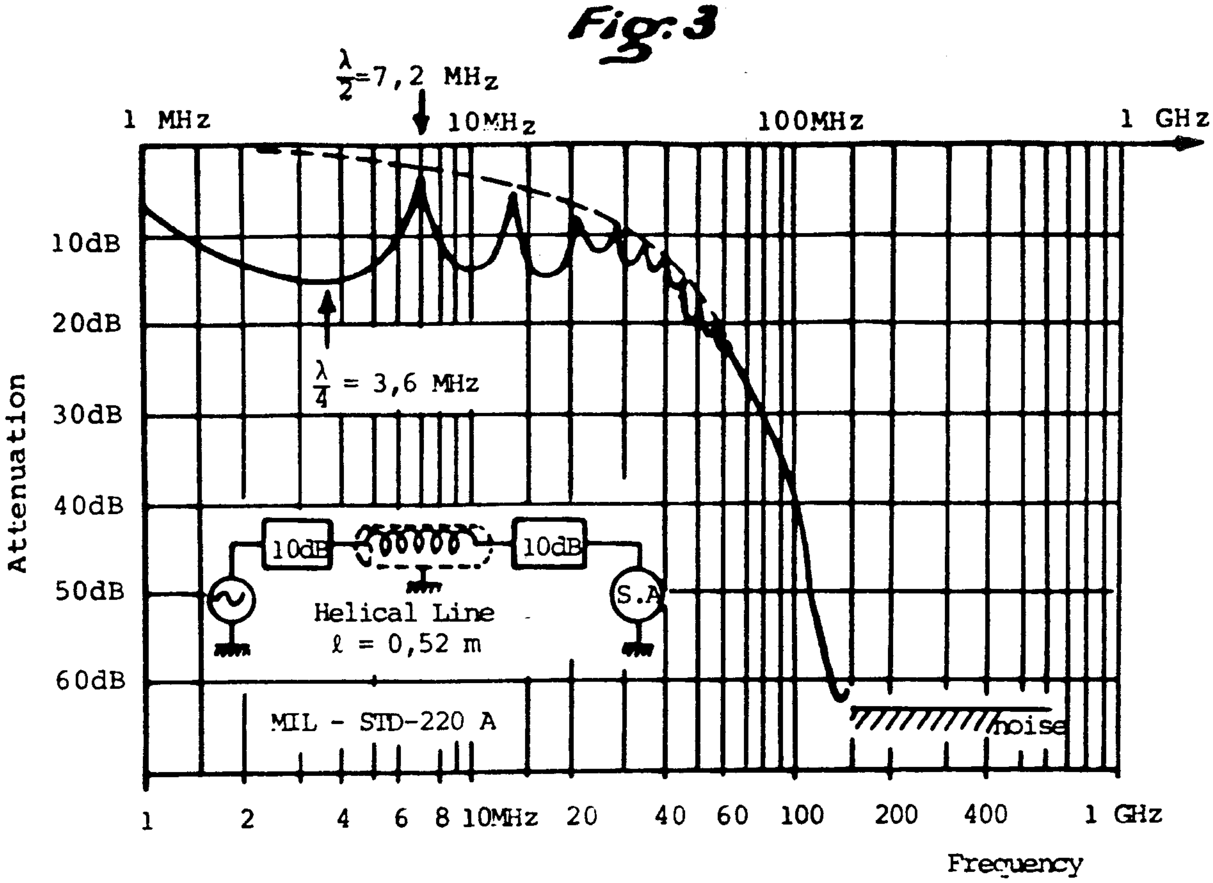
λ/2 = 7,2 MHz
1 MHz
10MHz
100MHz
1 GHz
10dB
20dB
30dB
40dB
50dB
60dB
Attenuation
λ/4 = 3,6 MHz
10dB
10dB
S.A
Helical Line
ℓ = 0,52 m
MIL - STD-220 A
noise
1 2 4 6 8 10MHz 20 40 60 100 200 400 1 GHz
Frequency

Fig: 4

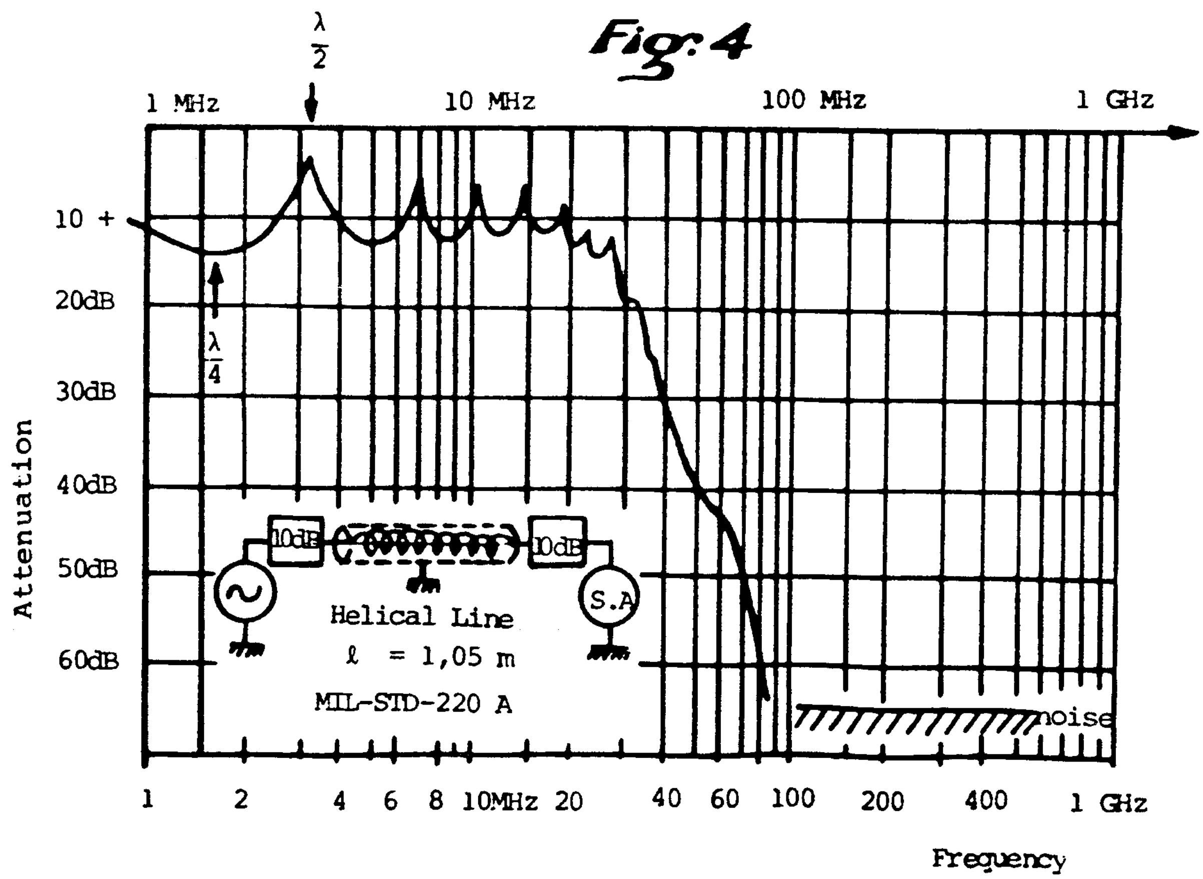
λ/2
1 MHz
10 MHz
100 MHz
1 GHz
10 +
20dB
30dB
40dB
50dB
60dB
Attenuation
λ/4
10dB
10dB
S.A
Helical Line
ℓ = 1,05 m
MIL-STD-220 A
noise
1 2 4 6 8 10MHz 20 40 60 100 200 400 1 GHz
Frequency

Fig: 5

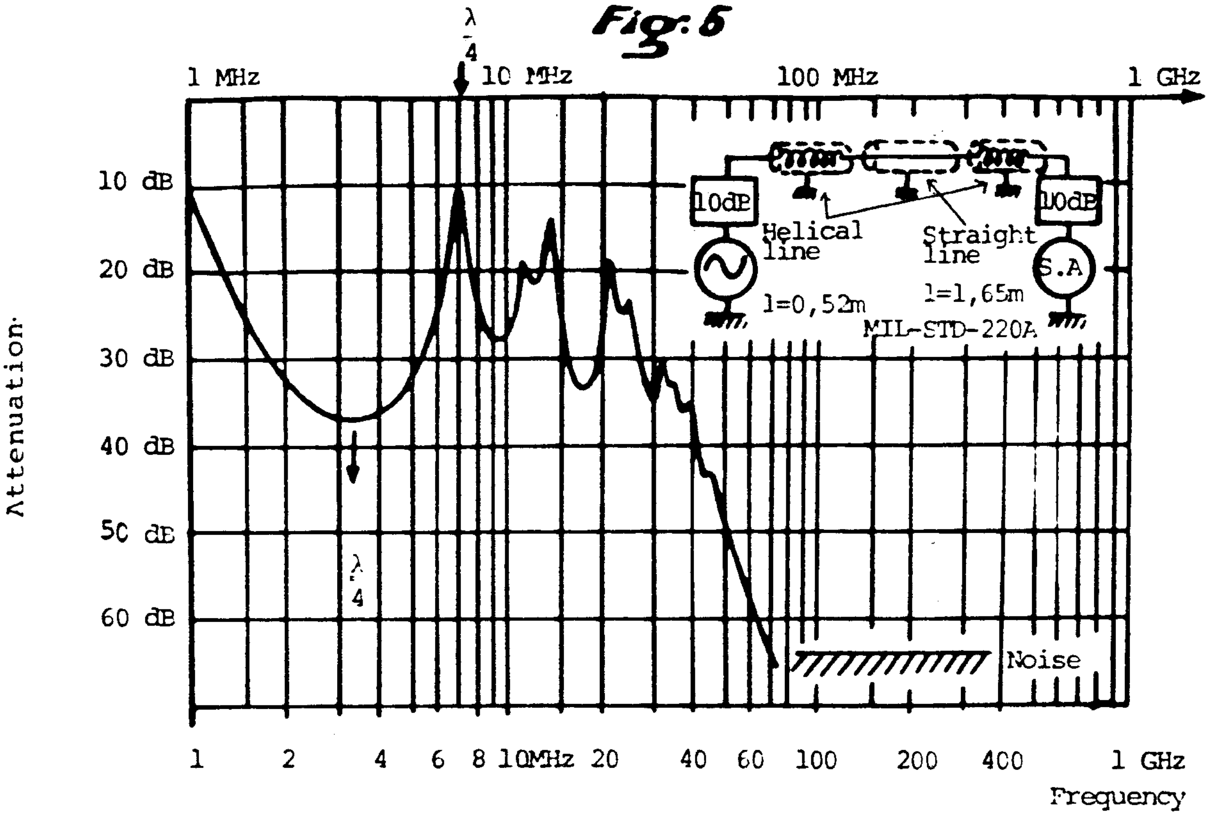
λ
4
1 MHz
10 MHz
100 MHz
1 GHz
10 dB
20 dB
30 dB
40 dB
50 dB
60 dB
Attenuation
10dB
10dB
Helical line
Straight line
S.A
l=0,52m
l=1,65m
MIL-STD-220A
λ
4
Noise
1
2
4
6
8
10MHz
20
40
60
100
200
400
1 GHz
Frequency

Fig: 6

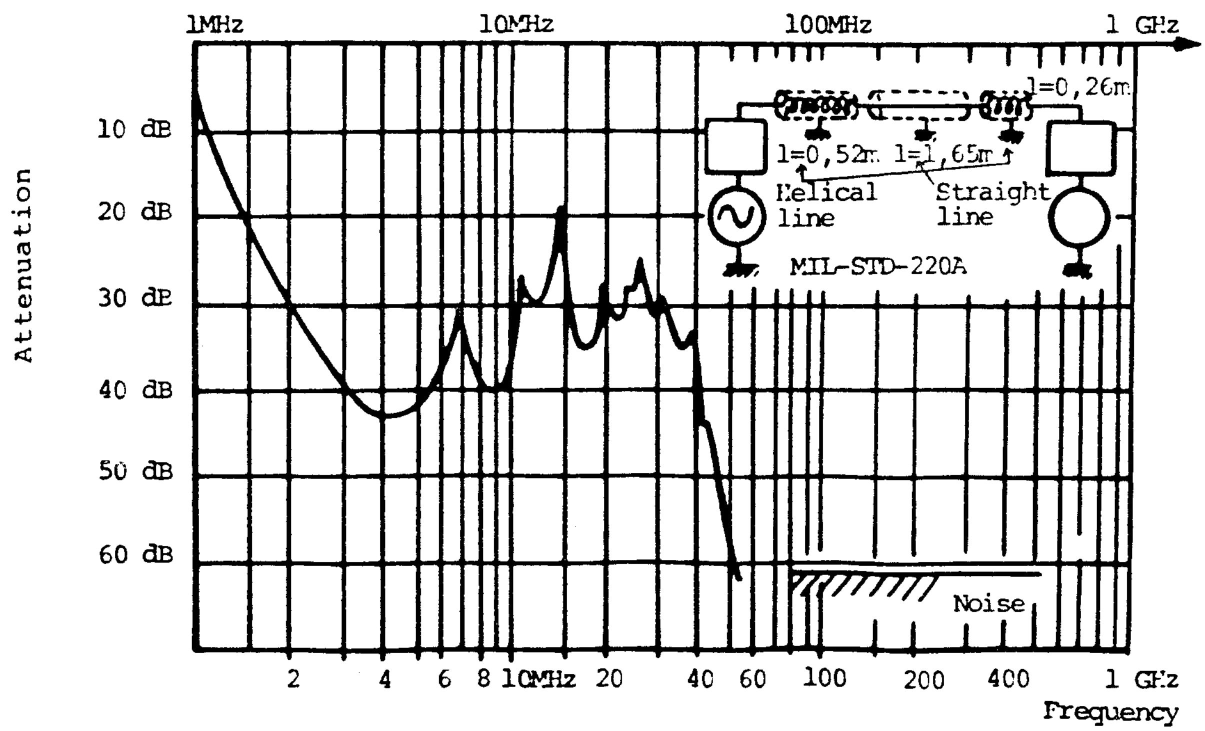
1MHz
10MHz
100MHz
1 GHz
10 dB
20 dB
30 dB
40 dB
50 dB
60 dB
Attenuation
l=0,26m
l=0,52m
l=1,65m
Helical line
Straight line
MIL-STD-220A
Noise
2
4
6
8
10MHz
20
40
60
100
200
400
1 GHz
Frequency

Fig. 7

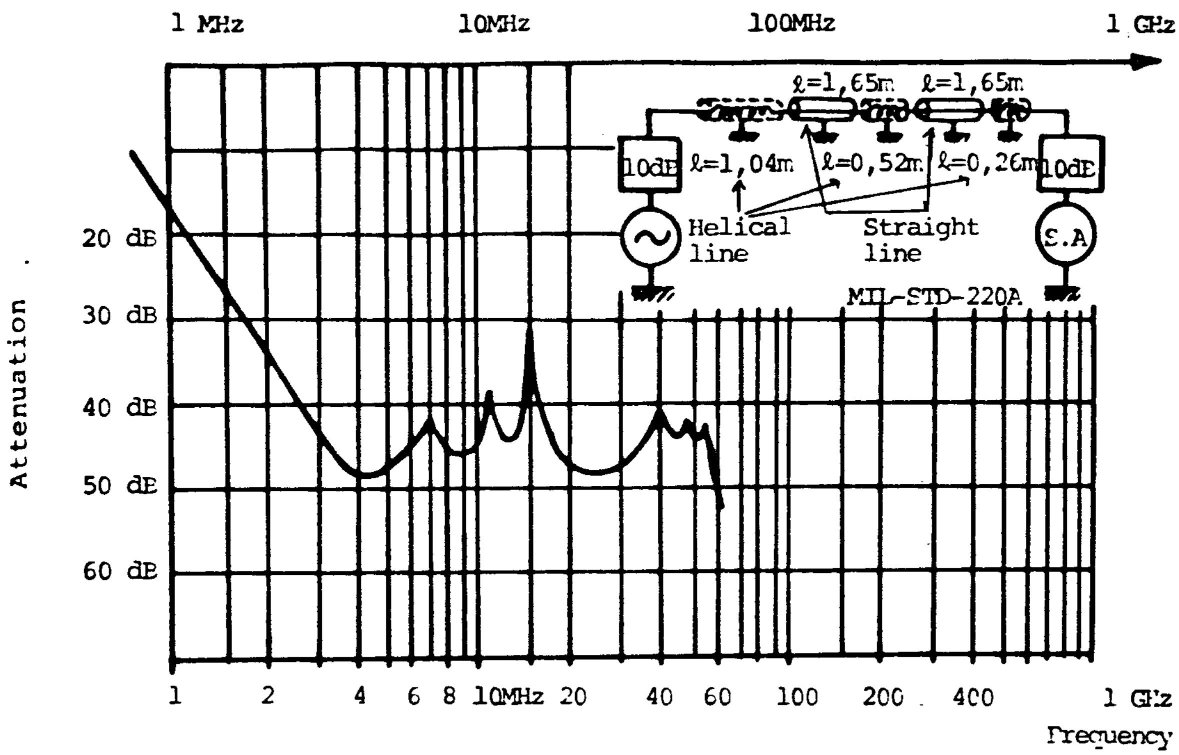
1 MHz
10MHz
100MHz
1 GHz
ℓ=1,65m
ℓ=1,65m
10dB
ℓ=1,04m
ℓ=0,52m
ℓ=0,26m
10dB
Helical line
Straight line
S.A
MIL-STD-220A
20 dB
30 dB
40 dB
50 dB
60 dB
Attenuation
1
2
4
6
8
10MHz
20
40
60
100
200
400
1 GHz
Frequency

Fig. 8

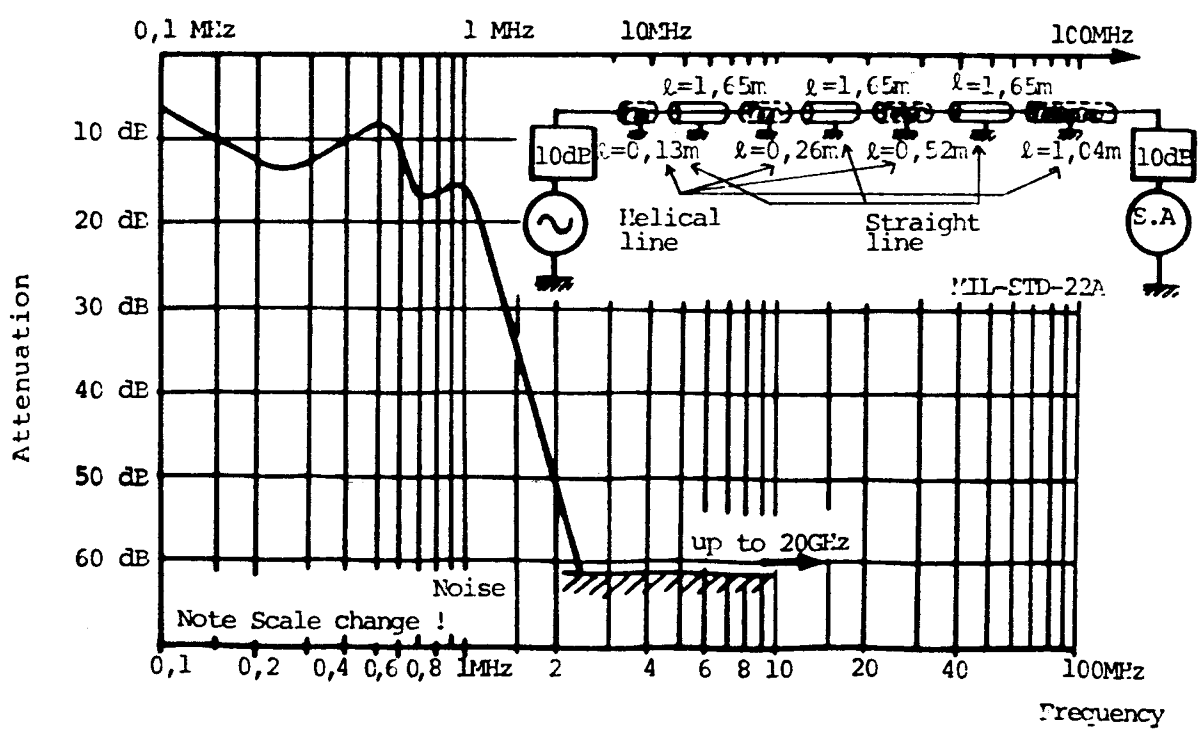
0,1 MHz
1 MHz
10MHz
100MHz
ℓ=1,65m
ℓ=1,65m
ℓ=1,65m
10dB
ℓ=0,13m
ℓ=0,26m
ℓ=0,52m
ℓ=1,04m
10dB
Helical line
Straight line
S.A
MIL-STD-22A
10 dB
20 dB
30 dB
40 dB
50 dB
60 dB
Attenuation
up to 20GHz
Noise
Note Scale change !
0,1
0,2
0,4
0,6
0,8
1MHz
2
4
6
8
10
20
40
100MHz
Frequency

Fig: 9

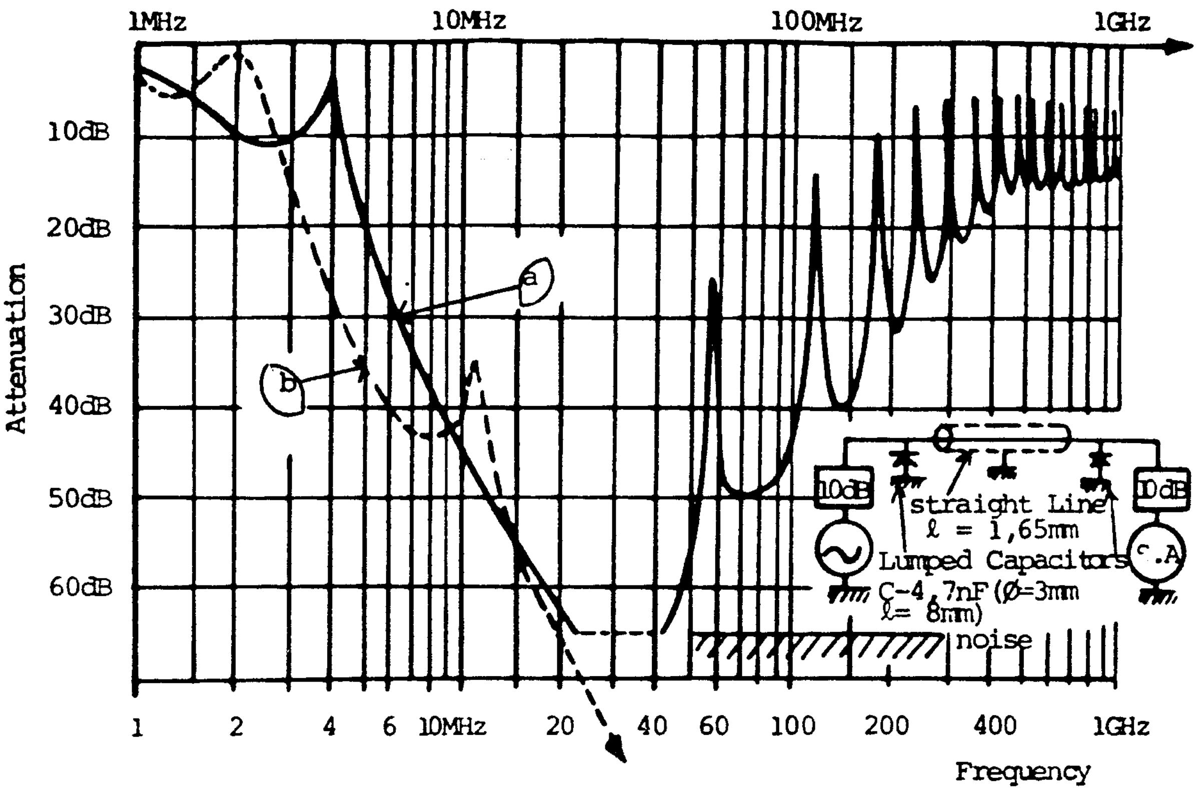
1MHz
10MHz
100MHz
1GHz
10dB
20dB
30dB
40dB
50dB
60dB
Attenuation
a
b
10dB
10dB
straight Line
ℓ = 1,65mm
Lumped Capacitors
C-4,7nF (Ø=3mm
ℓ= 8mm)
S.A
noise
1
2
4
6
10MHz
20
40
60
100
200
400
1GHz
Frequency

Fig: 10

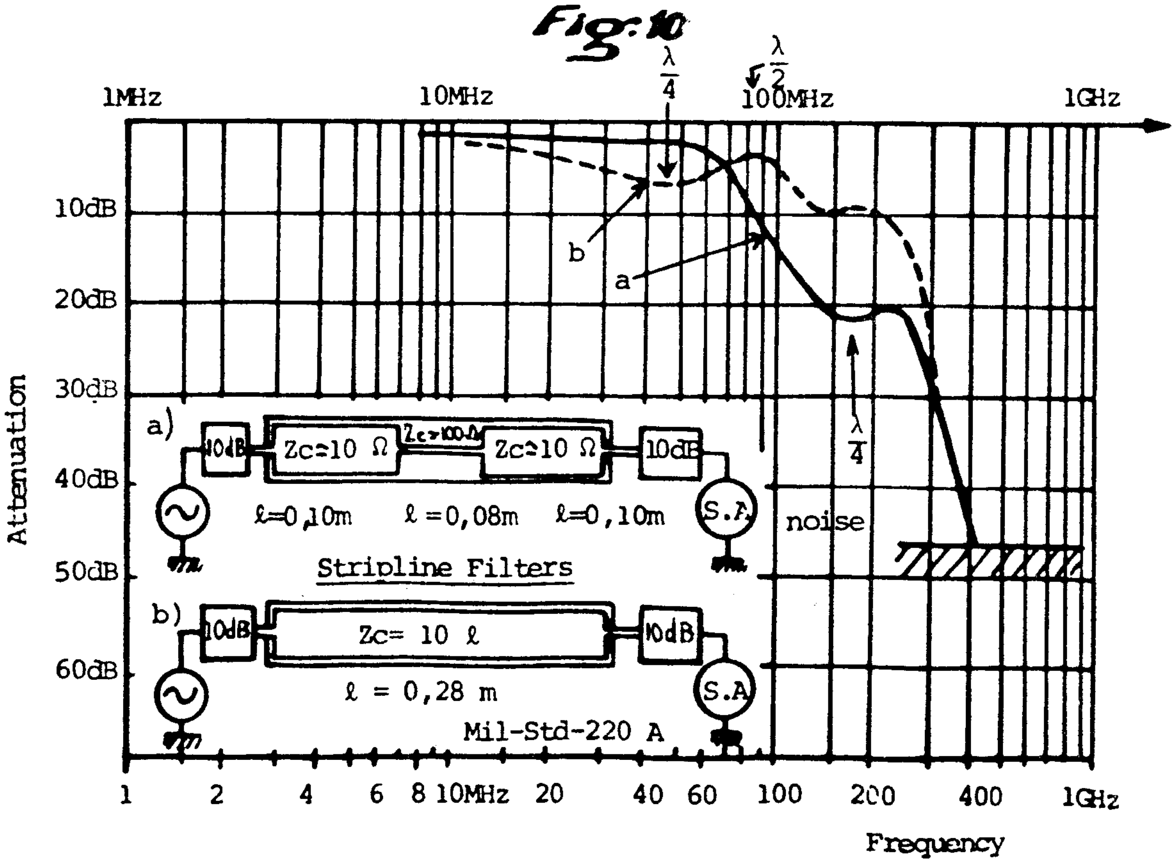
λ/4
λ/2
1MHz
10MHz
100MHz
1GHz
10dB
20dB
30dB
40dB
50dB
60dB
Attenuation
b
a
λ/4
noise
a)
10dB
Zc≃10 Ω
Zc≃100 Ω
Zc≃10 Ω
10dB
ℓ=0,10m
ℓ =0,08m
ℓ=0,10m
S.A
Stripline Filters
b)
10dB
Zc= 10 ℓ
10dB
ℓ = 0,28 m
S.A
Mil-Std-220 A
1
2
4
6
8 10MHz
20
40
60
100
200
400
1GHz
Frequency

Fig: 11

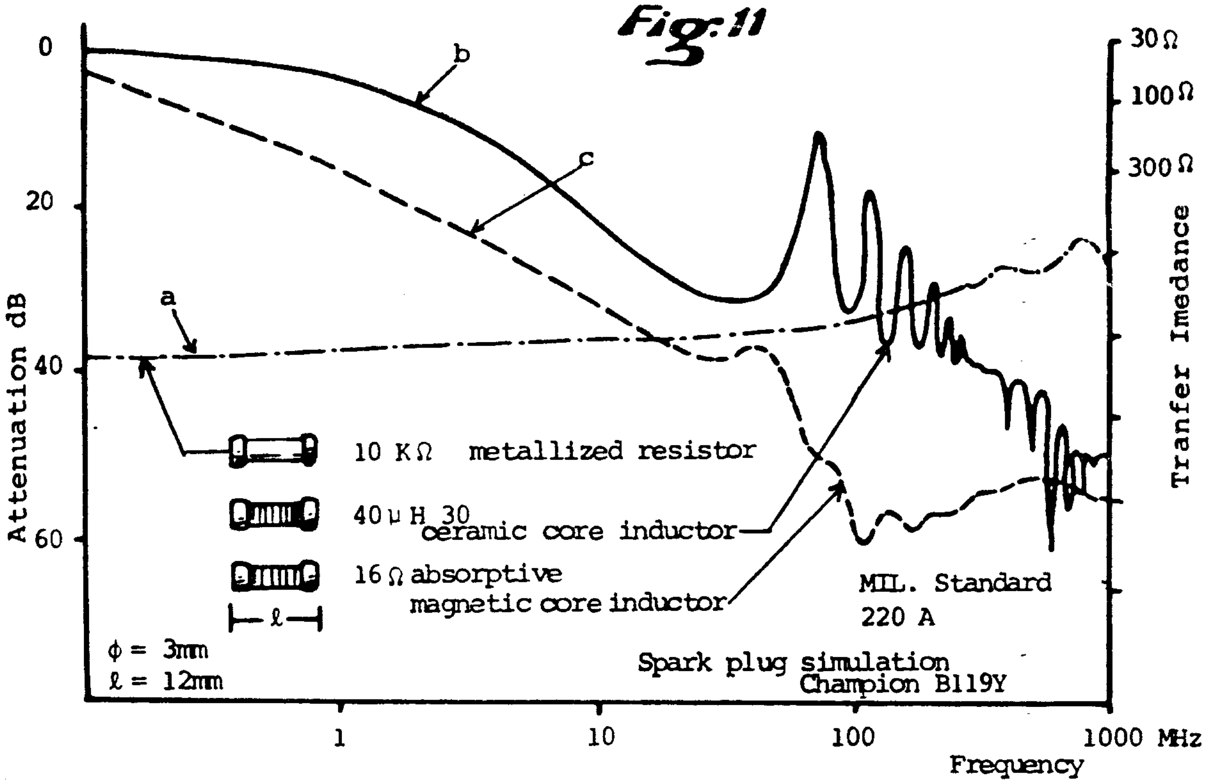
0
20
40
60
Attenuation dB
a
b
c
10 KΩ metallized resistor
40μH 30 ceramic core inductor
16Ω absorptive magnetic core inductor
ℓ
φ = 3mm
ℓ = 12mm
MIL. Standard 220 A
Spark plug simulation Champion B119Y
30Ω
100Ω
300Ω
Tranfer Imedance
1
10
100
1000 MHz
Frequency

Fig: 12

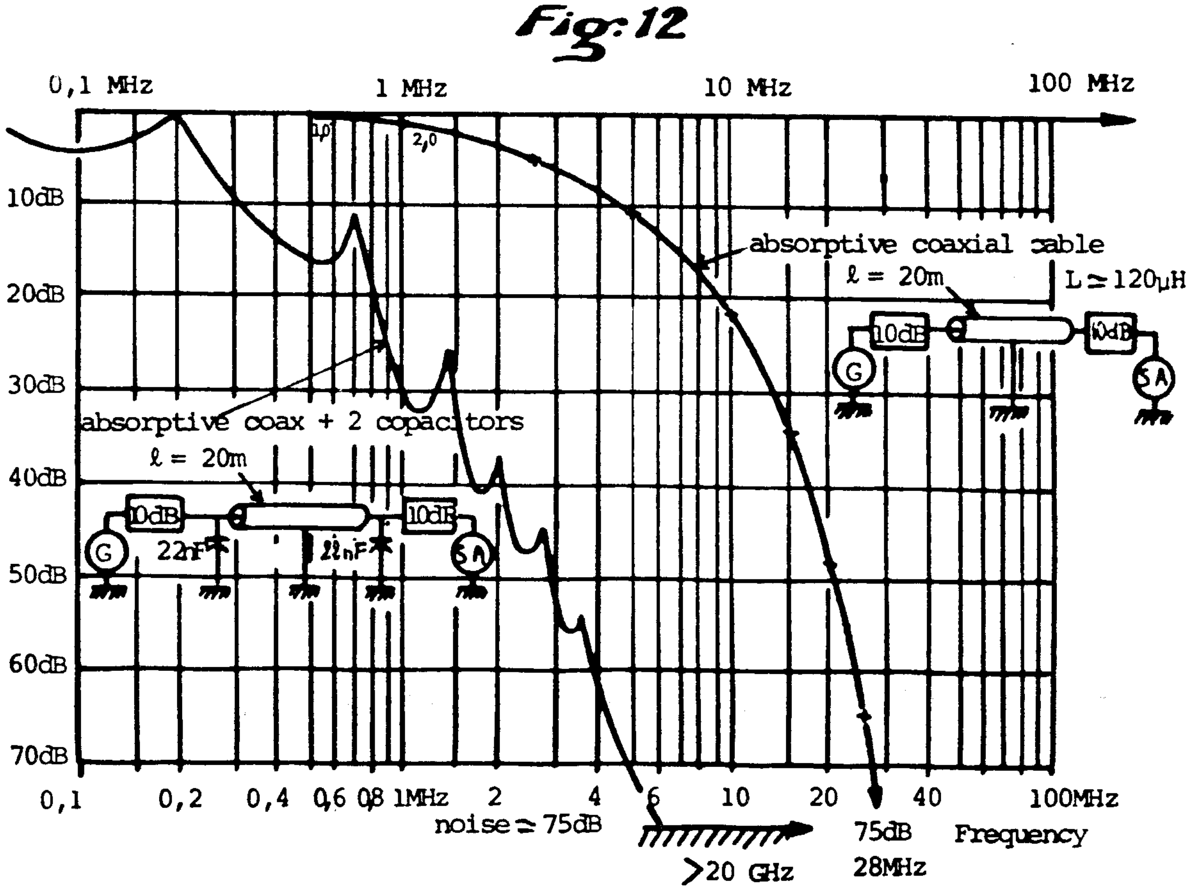
0,1 MHz
1 MHz
10 MHz
100 MHz
10dB
20dB
30dB
40dB
50dB
60dB
70dB
absorptive coaxial cable
ℓ = 20m
L ≃ 120μH
10dB
G
SA
absorptive coax + 2 copacitors
ℓ = 20m
22nF
22nF
0,1
0,2
0,4
0,6
0,8
1MHz
2
4
6
10
20
40
100MHz
noise ≃ 75dB
>20 GHz
75dB
28MHz
Frequency